# EUROPEAN PATENT APPLICATION

(11) **EP 3 349 553 A1**
(43) Date of publication of application: **18.07.2018**
(21) Application number: 17151458.1
(22) Date of filing: 13.01.2017
(51) Int. Cl.: H05K 3/24, H05K 3/46, H05K 3/34

(54) **COMPONENT CARRIER WITH PAD COVERED BY SURFACE FINISH-SOLDER STRUCTURE**

(71) Applicant: AT & S Austria Technologie & Systemtechnik Aktiengesellschaft, 8700 Leoben-Hinterberg (AT)
(72) Inventor: Leitgeb, Markus, 8793 Trofaiach (AT)
(74) Representative: Dilg, Haeusler, Schindelmann Patentanwaltsgesellschaft mbH

(57) **Abstract**

A method of manufacturing a component carrier (100), wherein the method comprises forming an interconnected stack (102) of at least one electrically insulating layer structure (104) and/or at least one electrically conductive layer structure (106), forming a pad (108) on a surface of the stack (102), and forming a combined surface finish-solder structure (110) on the pad (108) during manufacturing the component carrier (100).

## Description

The invention relates to component carriers, and a method of manufacturing a component carrier.

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. At the same time, component carriers shall be mechanically robust and electrically reliable so as to be operable even under harsh conditions.

Moreover, a proper connection of a component on and/or in a component carrier is an issue, in particular when connected by soldering.

It is an object of the invention to efficiently manufacture a component carrier capable of efficiently mounting a component thereon and/or therein.

In order to achieve the object defined above, component carriers and a method of manufacturing a component carrier according to the independent claims are provided.

According to an exemplary embodiment of the invention, a method of manufacturing a component carrier is provided, wherein the method comprises forming an interconnected stack of at least one electrically insulating layer structure and/or at least one electrically conductive layer structure, forming a pad on a surface of the stack, and forming a combined surface finish-solder structure on the pad during manufacturing the component carrier.

According to another exemplary embodiment of the invention, a component carrier is provided which comprises a stack of at least one electrically insulating layer structure and/or at least one electrically conductive layer structure, a pad on a surface of the stack, and a combined surface finish-solder structure on an entire exterior surface of the pad.

According to still another exemplary embodiment of the invention, a component carrier is provided which comprises a stack of at least one electrically insulating layer structure and/or at least one electrically conductive layer structure with a cavity in a surface portion of the stack, at least one pad in the cavity, and a common surface finish-solder structure on the pad.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above mentioned types of component carriers.

In the context of the present application, the term "surface finish" may particularly denote an electrically conductive cover material on exposed electrically conductive layer structures (such as pads, conductive traces, etc., in particular comprising or consisting of copper) on a surface of a component carrier such as a printed circuit board (PCB). If such exposed electrically conductive layer structures are left unprotected, then the exposed electrically conductive component carrier material (in particular copper) may oxidize and deteriorate, making the component carrier less reliable or even unusable. The surface finish forms the interface between a surface mounted (or a recessed) component and the component carrier. The surface finish has the function to protect the exposed electrically conductive layer structures (in particular copper circuitry) and enable a joining process with one or more components. Examples for appropriate materials for a surface finish are OSP (Organic Solderability Preservative), Electroless Nickel Immersion Gold (ENIG), and gold (in particular Hard Gold).

In the context of the present application, the term "solder structure" oder "solder" may particularly denote an electrically conductive material capable of forming a solder connection between two electrically conductive contacts of component carrier and component being wettable with the material of the solder structure. The solder structure may hence be a fusible metal or metal alloy used to create a permanent bond between the two electrically conductive contacts. In fact, the solder structure is melted by temperature or a combination of temperature and pressure in order to adhere to and connect the two electrically conductive contacts together. Preferably, the solder can be resistant to oxidative and corrosive effects that may degrade the joint over time. Examples for appropriate materials for a solder structure are SnAgCu, PbSn, etc.

In the context of the present application, the term "common surface finish-solder structure" (or "common surface finish inclusive solder structure" or "common surface finish including solder structure" or "common surface finish and solder structure") may particularly denote a single integral structure which is formed in a common procedure and fulfils both the function of a surface finish and of a solder structure. A common surface finish-solder structure fulfils both these technical functions and may be applied according to an exemplary embodiment of the invention as a single common structure rather than being provided by two separate bodies.

In the context of the present application, the term "structure" may particularly denote a body of any shape, such as a continuous or patterned layer, a bulky body, a three-dimensionally curved body, etc.

In the context of the present application, the term "soldering" may particularly denote a technique of joining different bodies (such as a pad and a component) by temporarily liquefying, melting or at least softening a solder material which forms an electromechanical joint after re-solidification or re-hardening. Thus, the process of soldering may involve the supply of thermal energy only, or a combination of a supply of thermal energy and mechanical pressure. Different kinds of soldering may be applied, in particular reflow soldering.

According to an exemplary embodiment of the invention, a combined surface finish-solder structure is applied on a component carrier prior to shipping the latter to a pick and place assembler which surface mounts an electronic component thereon (it is however also possible that a component is recessed in the component carrier and is mounted on the combined surface finish-solder structure). By taking this measure, the procedure of manufacturing a solder structure as a basis for soldering a component on the component carrier (which is conventionally done at a pick and place assembler) can be integrated in the surface finish production process so that two processes can be carried out together (in particular at the same time). This renders the manufacturing procedure more efficient and makes it dispensable that at a pick and place assembler, formation of a solder structure needs to be carried out. Formation of a solder structure may be carried out much more efficient at a component carrier manufacturer side, because here a surface finish procedure is usually applied anyhow, and an adaptation of this process allows to form the surface finish substantially simultaneously and in a common structure with the formation of the solder structure.

In the following, further exemplary embodiments of the component carriers and the method of manufacturing a component carrier will be explained.

In an embodiment, the method comprises forming the combined surface finish-solder structure prior to delivering the component carrier to a pick and place assembler for soldering a component on the pad by the surface finish-solder structure. This renders it dispensable for a pick and place assembler to care about the provision of a solder depot since the latter is already provided by the component carrier manufacturer.

In an embodiment, the method further comprises soldering the component on the pad by the combined surface finish-solder structure. Such a joining procedure may be embodied as a soldering procedure involving temporarily liquefying solder material, or may be embodied as a soldering procedure involving the application of heat and pressure for temporarily softening or melting the solder. Therefore, the common surface finish-solder structure may be directly used for accomplishing a solder connection of the component during a pick and place assembly process, without the need of manufacturing solderable material at this stage.

In an embodiment, the method comprises forming the combined surface finish-solder structure on the pad while being arranged on a planar main surface of the stack. For example, the pad covered with the common surface finish-solder structure may be applied on a main surface of a plate-like component carrier.

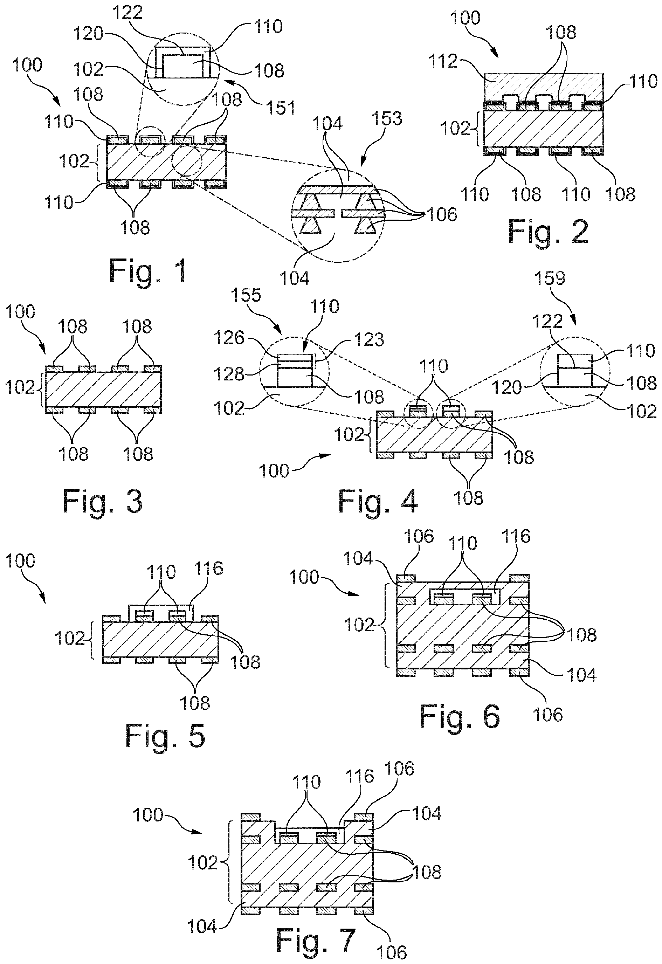

In another embodiment, the method comprises forming the combined surface finish-solder structure on the pad while being arranged in a cavity of the stack. According to such an embodiment, it is possible to form the common surface finish-solder structure even within a cavity (see the procedure according to Figure 3 to Figure 12), for instance to accomplish recessing. Conventionally, formation of solder structures in a cavity is very complicated because of technical, in particular geometrical, issues related with deposition of solder material using a dispensing device or the like. However, with the combined deposition of surface finish-solder structures, this is a technically feasible task, in particular when involving a release structure. When forming the combined surface finish-solder structure in a cavity, blind hole or recess, it can also be used in terms of recessing a component in an interior of the component carrier rather than surface mounting it.

However, the two previously described embodiments (i.e. arranging a pad on a planar main surface of the stack or in a cavity of the stack when forming the combined surface finish-solder structure) may also be combined. For instance, it is possible that a first pad is arranged on a planar main surface of the stack and a second pad is arranged in a cavity of the same stack when forming the combined surface finish-solder structure.

In an embodiment, the method comprises firstly covering the pad with the combined surface finish-solder structure and subsequently a surface portion of the stack on which the pad is arranged by a release structure (such as a release layer). Then, the stack and the release structure may be interconnected with at least one further electrically conductive layer structure and/or at least one further electrically insulating layer structure (in particular by lamination). Then, the combined surface finish-solder structure may be exposed again by removing material of the release structure and material of the at least one further electrically insulating layer structure and/or at least one further electrically conductive layer structure above the release structure. Thereby, it is possible to form a cavity (defined by the release structure) in which the combined surface finish-solder structure is positioned. The concept of providing a release structure may be applied on the basis of a material, such as a waxy component, which intentionally does not adhere to adjacent component carrier material (such as resin with reinforcing particles, a metal, etc.), so that the release structure spatially defines the later formed cavity. In such an embodiment, the pad and the combined surface finish-solder structure as well as adjacent component carrier material may be covered with the release structure. Then, both the release structure and still exposed component carrier material may be covered with a laminate material, such as further component carrier material. After that, the combined surface finish-solder structure may be exposed again by removing part of the laminated structure above the release layer and by removing the release layer, for instance by a (particularly laser) cutting procedure making use of the above described properties of the release structure. This allows to easily manufacture a pad covered with the common surface finish-solder structure in a cavity in a simple and reliable way. A release layer may be made of a material (for instance a waxy component) which has the property that it does not adhere to adjacent component carrier material, in particular prepreg, FR4 or the like. Thus, by simply cutting out a portion of the laminated material above the release structure will allow to simply take out a corresponding piece of this laminate, thereby obtaining a pad with common surface finish-solder structure within a cavity, without the need to apply material of the combined surface finish-solder structure into the cavity in a cumbersome manner.

In an embodiment, the combined surface finish-solder structure is formed by a surface finishing deposition process. In other words, a conventional surface finish deposition process may be adapted so that an additional material is added which later promotes soldering. Such a solderable material shall have the ability to melt at a certain temperature and to interconnect two elements (in particular pad and electric contact of component) upon reducing the temperature again (thereby solidifying also the solder material). By adding a solderable additive to a surface finish material, a common surface finish-solder structure is obtained without additional procedural effort.

In an embodiment, the combined surface finish-solder structure is formed by covering the pad with a mixture of a first material being specifically adapted as surface finish to protect the pad, and a separate second material being specifically adapted as solder structure for forming a solder connection between the pad and the component. The first material may for instance be OSP, ENIG or ENIPIG (Electroless Nickel Electroless Palladium Immersion Gold). The second material may for instance be SAC (Tin-Silver-Copper, SnAg-Cu), Sn-Bi-Ag, Sn-Pb or Sn-Cu.

In an embodiment, an entire exposed electrically conductive surface of the component carrier is fully covered with the combined surface finish-solder structure. In other words, the entire exposed surface of the component carrier which is made subject to the surface finishing procedure, will be covered by the common surface finish-solder structure. This can be the result of a selective surface finish deposition procedure which allows surface finish material to deposit only on an electrically conductive underground. However, since according to an exemplary embodiment of the invention a solder material is applied at the same time onto the pad during which also the surface finish material is applied, all surfaces which are electrically conductive can be covered by the integral or double layer structure of the combined surface finish-solder structure at the same time.

In a preferred embodiment, the combined surface finish-solder structure is a single common homogeneous layer including surface finish and solder. In this context, the term homogeneous may in particular mean that the combined surface finish-solder structure does not include two separate phases, one representing the surface finish and the other one representing the solder material, but have one uniform structure having constituents of both functional elements. For instance, the combined surface finish-solder structure can be an alloy with two or more metallic constituents one of which providing the solder function and the other one providing the surface finish function. Such a homogeneous structure may be the result of a common manufacturing procedure. Forming the combined surface finish-solder structure from a homogeneous material has an advantageous impact on adhesion properties of this common structure. Therefore, undesired delamination or formation of fissures at an interface between two materials can be suppressed or prevented by a homogeneous material composition. For instance, the common surface finish-solder structure embodied as a single homogeneous layer including surface finish and solder material may be HAL (Hot Air Levelling, or Immersion Tin (ISn).

In another embodiment, the common surface finish-solder structure is a double layer composed of a surface finish layer directly on the pad and a solder layer on the surface finish layer. The different layers may comprise or consist of different materials. It is also possible that any of the layers is composed of two or more sub-layers. The provision of a double layer of a surface finish layer and a solder structure layer thereon has the advantage that the materials of each of the layers may be selected separately in accordance with the respective function of the respective layer. Such an approach may be in particular advantageous in an architecture in which first the double layer is formed and subsequently the cavity is defined (for instance by an additive process). This renders it dispensable to form the double layer directly in a cavity with high effort. In such a double layer, the surface finish may be OSP (Organic Solderability Preservative), Electroless Nickel Immersion Gold (ENIG), or gold (in particular Hard Gold). In such a double layer, the solder layer may be SnAgCu or PbSn.

In an embodiment, the combined surface finish-solder structure covers both a side wall and a top wall of the pad. The pad may have a rectangular shape in a cross section through the component carrier. A bottom of the pad may be arranged on the stack of component carrier material, whereas the side walls and the top wall protruding over the component carrier material may be covered fully or substantially fully by the combined surface finish-solder structure. Thus, unlike conventional approaches, not only a top wall but also a side wall of a pad may be covered with a solder structure. This can be the procedural consequence of the formation of a surface finish having simultaneously also a solderable constituent or solderable properties, because surface finish may be deposited selectively on each and every electrically conductive surface portion of the component carrier. Such a solder structure covering not only a top but also side surfaces of a (in a cross-sectional view for instance strip-shaped or rectangular shaped) pad improves the reliability of a formed solder connection, since it allows to provide an extended solder depot and increased mechanical fixing.

In an embodiment, the component carrier further comprises a component soldered on the pad by the combined solder and surface finish structure. For instance, the component may have one or more component pads (for example when the component is a semiconductor chip) which may be solder connected with the one or more pads being arranged on the stack and being covered by the combined surface finish-solder structure.

Although some of the embodiments are described herein in terms of surface mounting the component, it should be said that the described concept of using a pad on a surface portion of a component carrier and being covered by a combined surface finish-solder structure, can also be implemented to recess the component in an interior of the component carrier (for instance using the described cavity concept). For recessing the component, it may for instance be advantageous to form the mentioned pad with the mentioned combined surface finish-solder structure in a cavity of the component carrier material, for instance an interconnected stack of electrically insulating layer structure(s) and/or electrically conductive layer structure(s). This further increases the flexibility of the architecture.

The at least one surface mounted and/or recessed component can be selected from a group consisting of an electrically non-conductive inlay, an electrically conductive inlay (such as a metal inlay, preferably comprising copper or aluminum), a heat transfer unit (for example a heat pipe), an electronic component, or combinations thereof. For example, the component can be an active electronic component, a passive electronic component, an electronic chip, a storage device (for instance a DRAM or another data memory), a filter, an integrated circuit, a signal processing component, a power management component, an optoelectronic interface element, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be surface mounted on and/or recessed and/or embedded in the component carrier. For example, a magnetic element can be used as a component. Such a magnetic element may be a permanent magnetic element (such as a ferromagnetic element, an antiferromagnetic element or a ferrimagnetic element, for instance a ferrite core) or may be a paramagnetic element. However, the component may also be a further component carrier, for example in a board-in-board configuration.

In an embodiment, the component carrier comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure, if desired supported by thermal energy. The mentioned stack may provide a plate-shaped component carrier capable of providing a large mounting surface for further components and being nevertheless very thin and compact. The term "layer structure" may particularly denote a continuous layer, a patterned layer or a plurality of non-consecutive islands within a common plane.

In an embodiment, the component carrier is shaped as a plate. This contributes to the compact design, wherein the component carrier nevertheless provides a large basis for mounting components thereon. Furthermore, in particular a naked die as example for a recessed electronic component, can be conveniently recessed, thanks to its small thickness, into a recess or cavity in a thin plate such as a printed circuit board.

In an embodiment, the component carrier is configured as one of the group consisting of a printed circuit board, and a substrate (in particular an IC substrate).

In the context of the present application, the term "printed circuit board" (PCB) may particularly denote a component carrier (which may be plate-shaped (i.e. planar), three-dimensionally curved (for instance when manufactured using 3D printing) or which may have any other shape) which is formed by laminating several electrically conductive layer structures with several electrically insulating layer structures, for instance by applying pressure, if desired accompanied by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming through-holes through the laminate, for instance by laser drilling or mechanical drilling, and by filling them with electrically conductive material (in particular copper), thereby forming vias as through-hole connections. Apart from one or more components which may be recessed and/or embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier having substantially the same size as a component (in particular an electronic component) to be mounted thereon. More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing spheres (such as glass spheres).

In an embodiment, the at least one electrically insulating layer structure comprises at least one of the group consisting of resin (such as reinforced or non-reinforced resins, for instance epoxy resin or Bismaleimide-Triazine resin, more specifically FR-4 or FR-5), cyanate ester, polyphenylene derivate, glass (in particular glass fibers, multi-layer glass, glass-like materials), prepreg material, polyimide, polyamide, liquid crystal polymer (LCP), epoxy-based Build-Up Film, polytetrafluoroethylene (Teflon), a ceramic, and a metal oxide. Reinforcing materials such as webs, fibers or spheres, for example made of glass (multilayer glass) may be used as well. Although prepreg or FR4 are usually preferred, other materials may be used as well. For high frequency applications, high-frequency materials such as polytetrafluoroethylene, liquid crystal polymer and/or cyanate ester resins may be implemented in the component carrier as electrically insulating layer structure.

In an embodiment, the at least one electrically conductive layer structure comprises at least one of the group consisting of copper, aluminum, nickel, silver, gold, palladium, and tungsten. Although copper is usually preferred, other materials or coated versions thereof are possible as well, in particular coated with supra-conductive material such as graphene.

In an embodiment, the component carrier is a laminate-type component carrier. In such an embodiment, the component carrier is a compound of multiple layer structures which are stacked and connected together by applying a pressing force, if desired accompanied by heat.

In an embodiment, the surface finish-solder structure has a thickness in a range between 0.1 µm and 5 µm, in particular in a range between 2 µm and 3 µm. Thus, the surface finish including solder deposit may be provided with a very thin layer thickness, preferably in a range between 0.1 µm and 5 µm.

In an embodiment, the surface finish-solder structure has a substantially uniform thickness. For instance, the thickness variations over the entire pad may be less than 50%, in particular may be less than 10%. This has a positive impact on the quality of the formed solder connection. Furthermore, this enables assembly of fine pitch components, i.e. components having a small distance between adjacent component pads of the component to be joint to the pads on the stack.

In an embodiment, the component has a pitch of not more than 400 µm. Thus, the surface finish including solder deposit may be specifically appropriate for fine pitch components. In this context, the term "pitch" may particularly denote a distance from a center of a component pad to a center of a neighboured component pad.

The aspects defined above and further aspects of the invention are apparent from the examples of embodiment to be described hereinafter and are explained with reference to these examples of embodiment.
Figure 1 and Figure 2 illustrate cross-sectional views of structures obtained during carrying out a method of manufacturing a component carrier and surface mounting a component thereon according to an exemplary embodiment of the invention.
Figure 3 to Figure 9 illustrate cross-sectional views of structures obtained during carrying out a method of manufacturing a component carrier and mounting a component therein according to another exemplary embodiment of the invention.
Figure 10 to Figure 12 illustrate cross-sectional views of structures obtained during carrying out a method of manufacturing a component carrier and mounting a component therein according to yet another exemplary embodiment of the invention.

The illustrations in the drawings are schematic. In different drawings, similar or identical elements are provided with the same reference signs.

Before, referring to the drawings, exemplary embodiments will be described in further detail, some basic considerations will be summarized based on which exemplary embodiments of the invention have been developed.

According to an exemplary embodiment of the invention, a component carrier such as a printed circuit board (PCB) with a pre-applied solder deposit is provided.

For assembling components on a component carrier such as a printed circuit board, a solder paste is conventionally applied on the component carrier. However, in particular in the event of fine line applications, screen printing for forming such solder paste can no longer be applied with high accuracy. This particularly holds when the components are to be mounted in cavities of the component carriers.

According to an exemplary embodiment of the invention, the solder paste or any other (for instance rigid) solderable material may already have been applied on the component carrier when the latter is shipped to a pick and place assembly for assembling the component. This means that a surface finish may be used which has integrated therein a solder depot. Alternatively, it is possible that additionally the end surface (for instance copper) in a cavity can be supplied with a solder depot already during manufacture of the component carrier. This may make it possible that the pick and place assembly procedure can be carried out in a simple way.

Figure 1 and Figure 2 illustrate cross-sectional views of structures obtained during carrying out a method of manufacturing a component carrier 100 and mounting a component 112 thereon according to an exemplary embodiment of the invention.

Referring to **Figure 1**, the method comprises laminating together electrically insulating layer structures 104 and electrically conductive layer structures 106 to thereby form an interconnected stack 102 of the electrically insulating layer structures 104 and the electrically conductive layer structures 106. In the shown embodiment, the electrically insulating layer structures 104 may comprise resin (such as epoxy resin) with reinforcing particles (such as glass fibers), for instance may be made of prepreg. The electrically conductive layer structures 106 may be made of copper. As shown in a detail 153, the electrically conductive layer structures 106 may comprise patterned metal layers (such as copper foils) and/or may comprise vertical interconnects (for instance copper filled laser vias).

Furthermore, one or more electrically conductive pads 108 are formed on one or (as shown) both opposing main surfaces of the stack 102, for instance by attaching or depositing a layer of electrically conductive material (such as copper) and by patterning the latter (for instance by a lithography and etching procedure).

As can be taken from Figure 1 as well (see in particular further detail 151), a (here curved or cap-shaped) layer of a combined surface finish-solder structure 110 is thereafter formed selectively on the pads 108 as the only exposed electrically conductive (here copper) surface of the stack 102 with the pads 108 thereon. The common surface finish-solder structure 110 is here embodied as a single homogeneous layer including both a surface finish constituent and a solder material constituent. More specifically, the combined surface finish-solder structure 110 is formed on the pads 108 while they are arranged on a planar main surface of the stack 102. A complicated deposition of surface finish and/or solder material within a cavity by screen printing or the like can therefore be advantageously prevented. In the described embodiment, the combined surface finish-solder structure 110 is formed by a surface finishing deposition process, i.e. by carrying out a conventional surface finishing deposition process but adding a further constituent during this process for further promoting or enhancing the capability of the formed combined surface finish-solder structure 110. Consequently, the latter synergetically serves also as a solder material for later establishing a solder connection between pad 108 and an electronic component 112 (see Figure 2). As can be taken from further detail 151 as well, the combined surface finish-solder structure 110 covers both a top surface (or top wall 122) as well as side surfaces (or side walls 120) of the pads 108. Thus, the combined surface finish-solder structure 110 covers the entire exposed surface of the pads 108. This has the advantage of an improved adhesion between pad 108, common surface finish-solder structure 110 and a component 112 joined thereon as a consequence of the increased connection area for accomplishing a mechanical fixation. Advantageously, the combined surface finish-solder structure 110 of Figure 1 is a single common homogeneous (here in terms of both material composition as well as layer thickness) layer including surface finish and solder, i.e. fulfilling two functions simultaneously.

As a result of the described manufacturing procedure, component carrier 100 according to an exemplary embodiment of the invention and as shown in Figure 1 is obtained. The component carrier 100 is composed of the stack 102, and the pads 108 fully capped with the combined surface finish-solder structure 110. In the shown embodiment, the component carrier 100 is configured as laminate-type component carrier 100, is shaped as a flat plate and is configured as a printed circuit board (PCB). The component carrier 100 is ready for component assembly, and is even already provided with an integral solder depot before shipment of the component carrier 100 to a component assembly site. In other words, the formation of the combined surface finish-solder structure 110, as shown in Figure 1, can be carried out and completed prior to delivering the component carrier 100 to a pick and place assembler for soldering a component 112 on the pad 108 by the surface finish-solder structure 110 (see Figure 2).

The cross-sectional view of Figure 1 shows that the common surface finish-solder structure 110 surrounds the rectangular strip-shaped pad 108 with a substantially U-shaped structure. This is a consequence of the fact that the formation of this common surface finish-solder structure 110 during a surface finishing procedure results in a deposition of the combined surface finish-solder structure 110 on all exposed electrically conductive surfaces of the component carrier 100. It is hence sufficient that an unspecific surface finishing procedure is carried out which automatically results in the formation of the common surface finish-solder structure 110 on the correct surface portions. Detail 151 in Figure 1 shows that the - in a cross sectional view - U-shape of the combined surface finish-solder structure 110 differs from the shape of a conventional solder paste (which conventionally only covers a top surface of pads).

Referring to **Figure 2**, the component 112 is soldered on the pads 108 by the combined surface finish-solder structure 110. For instance, the component 112 is an electronic component such as a semiconductor chip. The component 112 is mounted on the stack 112 composed of the electrically insulating layer structures 104 and the electrically conductive layer structures 106. As a result, the component 112 may be electrically coupled via the common surface finish-solder structure 110 to the various electrically conductive layer structures 106 in any desired way. During soldering, at least the solder material constituent of the common surface finish-solder structure 110 melts and then resolidifies to thereby establish a reliable electric and mechanical coupling between the wettable pads 108 and corresponding wettable component pads with material of the common surface finish-solder structure 110 in between.

More specifically, Figure 2 shows that four component pads of the component 112 are electrically coupled simultaneously with four pads 108 on the stack 102 each of which being covered by one of the common surface finish-solder structures 110 applied to the stack 102. As can furthermore be taken from Figure 1 and Figure 2, both opposing main surfaces of the stack 102 are covered by an array of pads 108 each of which being covered by a respective common surface finish-solder structure 110. Since all common surface finish-solder structures 110 may be manufactured simultaneously, a very efficient manufacturing procedure can be carried out. It is possible that the lower main surface of the component carrier 100 according to Figure 2 is connected to a further component 112 (not shown), or to any other board or electronic base.

Figure 3 to Figure 9 illustrate cross-sectional views of structures obtained during carrying out a method of manufacturing a component carrier 100 and mounting a component 112 therein according to another exemplary embodiment of the invention.

Referring to **Figure 3**, a stack 102 with pads 108 thereon corresponding to what is shown in Figure 1 is provided or formed as a starting point for the further process.

Based on the structure shown in Figure 3, a part of the exposed pads 108 may then be covered by a respective common surface finish-solder structure 110, as shown in **Figure 4**. In contrast to Figure 1 and Figure 2, only some (but not all) of the pads 108 are covered with material of the common surface finish-solder structure 110. Even these covered pads 108 are only covered partially with the common surface finish-solder structure 110, i.e. only on their top wall 122, but not on their side walls 120. This has the advantages of a lower amount of material of the common surface finish-solder structure 110 and a simple and flexible design.

As shown in yet another detail 159, the common surface finish-solder structure 110 may be a homogeneous single layer, as in Figure 1 and Figure 2. The common surface finish-solder structure 110 according to detail 159 has the advantage of a simple manufacturing procedure and of a high degree of homogeneity in terms of material properties and layer thickness, and does not involve an additional material interface.

Still another detail 155 of Figure 5 shows an alternative to detail 159. As can be taken from this detail 155, it is possible that a double layer 123 of a first layer of surface finish 128 and a second solder layer 126 is applied on the pad 108. In other words, the common surface finish-solder structure 110 is here embodied as a double layer 123 composed of surface finish 128 directly on the pad 108 and solder layer 126 directly on the surface finish 128.

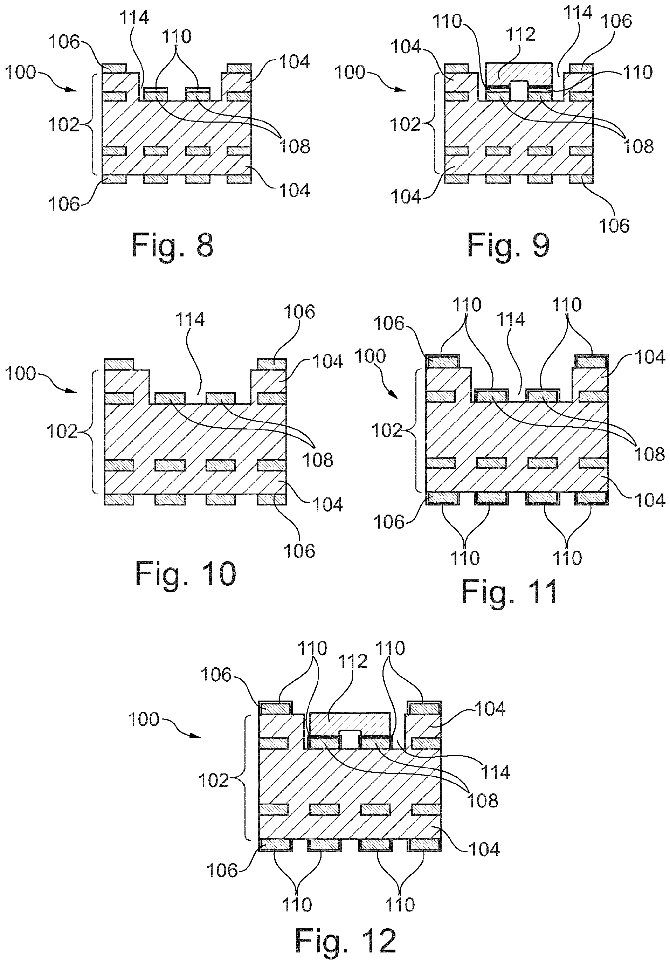

Referring to **Figure 5**, the pads 108 covered with the combined surface finish-solder structure 110 and an adjacent surface portion of the stack 102 are selectively covered by a release structure 116. The release structure 116 may be made of a material (such as a waxy medium) which does not adhere to component carrier material, i.e. to the material of the electrically insulating layer structures 104 and of the electrically conductive layer structures 106 of stack 102. More precisely, the release structure 116 may be applied selectively on a surface portion in which a cavity 114 shall be formed (see Figure 8). This can for instance be accomplished by a selective application of the material of the release structure 116, for instance by applying it by screen printing. Alternatively, a full layer of the material of the release structure 116 may be applied on the upper main surface of the structure shown in Figure 4, and subsequently this structure may be patterned, for instance by a combined lithography and etching procedure.

Referring to **Figure 6**, the structure shown in Figure 5 is interconnected on both opposing main surfaces thereof with further electrically conductive layer structures 106 (such as copper foils) and further electrically insulating layer structures 104 (such as prepreg foils) by lamination. Thereby, the release structure 116 is recessed in an interior of the so obtained structure.

In order to obtain the structure shown in **Figure 7**, a (for instance laser) cutting procedure may be carried out which circumferentially (not seen in the cross sectional view of Figure 7) cuts out a section of the laminated material above the release structure 116. The separated section or piece can be simply taken out due to the non-adhering property of the release structure 116 with regard to surrounding material.

Referring to **Figure 8**, the combined surface finish-solder structure 110 is exposed by removing the non-adhering sacrificial release structure 116. Thus, the release structure 116, being exposed as a result of the above described cutting procedure, may be removed from the remainder of the component carrier 100 shown in Figure 7 in a very simple way. As a result, a cavity 114 is formed in which the combined surface finish-solder structure 110 is already arranged. Advantageously, formation of a combined surface finish-solder structure 110 in a pre-formed cavity 114 is dispensable with the described procedure.

As a result, component carrier 100 of Figure 8 is provided which is composed of the stack 102 of the electrically insulating layer structures 104 and the electrically conductive layer structures 106 with the cavity 114 in a surface portion of the stack 102. Pads 108 being partially covered by the common surface finish-solder structure 110 are exposed in the cavity 114 for a subsequent component assembly by soldering without the need of separately forming a solder depot thereon. In particular in the event of solder mask defined pads 108 in a cavity 114, as shown in Figure 8, it is possible that there is no material of the common surface finish-solder structure 110 on the side walls 120 of the pads 108. According to Figure 8, the common surface finish-solder structure 110 hence covers only a top wall 122, not side walls 120, of the pads 108 in the cavity 114.

**Figure 9** shows the structure of Figure 8 after the component 112 has been soldered directly onto the now exposed common surface finish-solder structures 110 so as to establish an electrically conductive and mechanical connection between the component 112 and the pads 108 via the common surface finish-solder structure 110. As can be taken from Figure 9, the component 112 is now mounted on the pads 108 by a solder connection and recessed within the cavity 114, which is a consequence of the temporary use of the release structure 116. Therefore, implementation of common surface finish-solder structure 110 is not only possible in a planar geometry (as shown in Figure 1 and Figure 2), but also in terms of recessing component 112 in cavity 114 of component carrier 100.

Figure 10 to Figure 12 illustrate cross-sectional views of structures obtained during carrying out a method of manufacturing a component carrier 100 and mounting a component 112 therein according to yet another exemplary embodiment of the invention. Figure 10 to Figure 12 thus relate to a scenario in which the cavity 114 is formed before formation of the combined surface finish-solder structure 110.

According to **Figure 10**, a structure similar to Figure 8 is formed, but still without common surface finish-solder structure 110.

According to **Figure 11**, common surface finish-solder structure 110 is formed on all pads 108 by deposition based on the structure of Figure 10. Thus, the combined surface finish-solder structure 110 is formed on the pads 108 in cavity 114 while being arranged in a cavity 114 of the stack 102. Also pads 108 on an opposing planar lower main surface of stack 102 are covered by the common surface finish-solder structure 110. According to Figure 11, the common surface finish-solder structure 110 covers both a side wall 120 and a top wall 122 of the pads 108 in the cavity 114.

According to **Figure 12**, the component 112 has been soldered onto the pads 108 using the common surface finish-solder structure 110 in the cavity 114 for establishing the solder connection. Also with the procedure according to Figure 10 to Figure 12, a cumbersome application of a solder depot into cavity 114 by screen printing can be avoided.

It should be noted that the term "comprising" does not exclude other elements or steps and the "a" or "an" does not exclude a plurality. Also elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants are possible which use the solutions shown and the principle according to the invention even in the case of fundamentally different embodiments.

## Claims

1. A method of manufacturing a component carrier (100), wherein the method comprises:
forming an interconnected stack (102) of at least one electrically insulating layer structure (104) and/or at least one electrically conductive layer structure (106);
forming a pad (108) on a surface of the stack (102);
forming a combined surface finish-solder structure (110) on the pad (108) during manufacturing the component carrier (100).

2. The method according to claim 1, comprising at least one of the following features:
wherein the method comprises forming the combined surface finish-solder structure (110) prior to delivering the component carrier (100) to a pick and place assembler for soldering a component (112) on the pad (108) by the surface finish-solder structure (110);
wherein the method further comprises soldering the component (112) on the pad (108) by the combined surface finish-solder structure (110);
wherein the method comprises forming the combined surface finish-solder structure (110) on the pad (108) while being arranged on a planar main surface of the stack (102).

3. The method according to claim 1 or 2, wherein the method comprises forming the combined surface finish-solder structure (110) on the pad (108) while being arranged in a cavity (114) of the stack (102).

4. The method according to any of claims 1 to 3, wherein the method comprises:
covering the pad (108) with the combined surface finish-solder structure (110) and subsequently a surface portion of the stack (102) on which the pad (108) is arranged by a release structure (116);
connecting the stack (102) and the release structure (116) with at least one further electrically conductive layer structure (106) and/or at least one further electrically insulating layer structure (104);
exposing the combined surface finish-solder structure (110) by removing material of the release structure (116) and material of the at least one further electrically insulating layer structure (104) and/or at least one further electrically conductive layer structure (106) above the release structure (116) to thereby form a cavity (114) in which the combined surface finish-solder structure (110) is arranged.

5. The method according to any of claims 1 to 4, wherein the combined surface finish-solder structure (110) is formed by a surface finishing deposition process.

6. The method according to any of claims 1 to 5, wherein the combined surface finish-solder structure (110) is formed by covering the pad (108) with a mixture of:
a first material being specifically adapted as surface finish to protect the pad (108); and
a separate second material being specifically adapted as solder structure for forming a solder connection between the pad (108) and a component (112) to be mounted on the component carrier (100).

7. A component carrier (100), wherein the component carrier (100) comprises:
a stack (102) of at least one electrically insulating layer structure (104) and/or at least one electrically conductive layer structure (106);
a pad (108) on a surface of the stack (102);
a combined surface finish-solder structure (110) on an entire exterior surface of the pad (108).

8. The component carrier (100) according to claim 7, comprising at least one of the following features:
wherein an entire exposed electrically conductive surface of the component carrier (100) is fully covered with the combined surface finish-solder structure (110);
wherein the combined surface finish-solder structure (110) is a single common homogeneous layer including a surface finish and a solder structure;
wherein the combined surface finish-solder structure (110) covers both a side wall (120) and a top wall (122) of the pad (108).

9. The component carrier (100) according to claim 7 or 8, further comprising a component (112) soldered on the pad (108) by the combined surface finish-solder structure (110).

10. The component carrier (100) according to claim 9, comprising at least one of the following features:
wherein the component (112) is mounted on and/or recessed in the at least one electrically insulating layer structure (104) and/or the at least one electrically conductive layer structure (106);
wherein the component (112) is selected from a group consisting of an electronic component, an electrically non-conductive and/or electrically conductive inlay, a heat transfer unit, an energy harvesting unit, an active electronic component, a passive electronic component, an electronic chip, a storage device, a filter, an integrated circuit, a signal processing component, a power management component, an optoelectronic interface element, a voltage converter, a cryptographic component, a transmitter and/or receiver, an electromechanical transducer, an actuator, a microelectromechanical system, a microprocessor, a capacitor, a resistor, an inductance, an accumulator, a switch, a camera, an antenna, a magnetic element, a further component carrier and a logic chip;
wherein the component (112) has a pitch of not more than 400 µm.

11. The component carrier (100) according to any of claims 7 to 10, comprising at least one of the following features:
wherein the at least one electrically conductive layer structure (106) comprises at least one of the group consisting of copper, aluminum, nickel, silver, gold, palladium, and tungsten, any of the mentioned materials being optionally coated with supra-conductive material such as graphene;
wherein the at least one of the electrically insulating layer structure (104) comprises at least one of the group consisting of resin, in particular reinforced or non-reinforced resin, for instance epoxy resin or Bismaleimide-Triazine resin, FR-4, FR-5, cyanate ester, polyphenylene derivate, glass, prepreg material, polyimide, polyamide, liquid crystal polymer, epoxy-based Build-Up Film, polytetrafluoroethylene, a ceramic, and a metal oxide;
wherein the component carrier (100) is configured as one of the group consisting of a printed circuit board, and an integrated circuit (IC) substrate;
configured as a laminate-type component carrier (100).

12. A component carrier (100), comprising:
a stack (102) of at least one electrically insulating layer structure (104) and/or at least one electrically conductive layer structure (106) with a cavity (114) in a surface portion of the stack (102);
a pad (108) in the cavity (114);
a common surface finish-solder structure (110) on the pad (108).

13. The component carrier (100) according to claim 12, comprising one of the following features:
wherein the common surface finish-solder structure (110) is a single homogeneous layer including a surface finish and a solder structure;
wherein the common surface finish-solder structure (110) is a double layer (123) composed of a surface finish (128) directly on the pad (108) and a solder layer (126) on the surface finish (128).

14. The component carrier (100) according to claim 12 or 13, comprising one of the following features:
wherein the common surface finish-solder structure (110) covers both a side wall (120) and a top wall (122) of the pad (108) in the cavity (114);
wherein the common surface finish-solder structure (110) covers only a top wall (122) of the pad (108) in the cavity (114).

15. The component carrier (100) according to any of claims 7 to 14, comprising at least one of the following features:
wherein the surface finish-solder structure (110) has a thickness in a range between 0.1 µm and 5 µm, in particular in a range between 2 µm and 3 µm;
wherein the surface finish-solder structure (110) has a substantially uniform thickness.
